# EUROPEAN PATENT SPECIFICATION

(11) **EP 1 493 845 B1**
(45) Date of publication and mention of the grant of the patent: **16.11.2016**
(21) Application number: 04445061.7
(22) Date of filing: 14.05.2004
(51) Int. Cl.: C23C 30/00, C23C 16/30

(54) **CVD coated cutting tool insert**
CVD beschichteter Schneidwerkzeugeinsatz
Plaquette d'outil coupant revêtue par CVD

(30) Priority: 16.06.2003 SE 0301742
(43) Date of publication of application: 05.01.2005
(73) Proprietor: Seco Tools AB, 737 82 Fagersta (SE)
(72) Inventor: Larsson, Andreas, 737 47 Fagersta (SE); Sulin, Anette, 737 43 Fagersta (SE); Pettersson, Lena, 737 90 Angelsberg (SE); Ruppi, Sakari, 737 44 Fagersta (SE)
(74) Representative: Taquist, Henrik Lennart Emanuel

(56) References cited:
- EP-A- 1 008 673
- EP-A- 1 038 989
- EP-A- 1 103 635
- EP-A- 1 288 335
- US-A- 6 062 776
- US-B1- 6 221 479
- PATENT ABSTRACTS OF JAPAN vol. 2000, no. 21, 3 August 2001 (2001-08-03) -& JP 2001 087907 A (MITSUBISHI MATERIALS CORP), 3 April 2001 (2001-04-03)

## Description

The present invention relates to a coated cemented carbide insert (cutting tool), particularly useful for milling of stainless steels and super alloys but also milling of steels in toughness demanding applications.

During milling of various materials with coated cemented carbide cutting tools, the cutting edges are regarded as being worn according to different wear mechanisms. Wear types such as chemical wear, abrasive wear and adhesive wear, are rarely encountered in a pure state, and complex wear patterns are often the result. The domination of any of the wear mechanisms is determined by the application, and is dependent on both properties of the work piece and applied cutting parameters as well as the properties of the tool material. At high cutting speeds, the amount of heat generated in the cutting zone is considerable and a plastic deformation of the cutting edge may occur, which in turn yields an enhanced wear by other mechanisms. The tool life is also often limited by edge chipping caused by so-called comb cracks that form perpendicular to the cutting edge. The cracks originate from the varying thermal and mechanical loads that the cutting edge is subjected to during the intermittent cutting process. This is often even more evident in machining with coolant, which enhances the thermal variations.

Many stainless steels in general, and super alloys in particular, possess material properties that are most unfavourable from a machinability point of view, when compared to steels. The low thermal conductivity of these materials results in high temperatures in the tool and work piece contact zones. The use of coolant to reduce the tool temperature can give very large thermal variations and induce high internal tool loads. These work piece materials are also often prone to deformation hardening. Deformation hardening of the work piece in the cutting zone can result in high cutting forces, or even cutting in a hardened layer, which both will lead to accelerated tool wear. Furthermore, most stainless steels and super alloys show good adherence towards many coating materials and adhesive wear and rapid chipping of the tool edge due to re-cutting of chips can be substantial. It is thus clear that coated cemented carbide tools intended for use in milling of stainless steels and super alloys must have properties often extending those that are generally needed for tool materials.

In general, measures can be taken to improve the cutting performance with respect to a specific wear type. However, very often such actions will have a negative effect on other wear properties and successful tool composite materials must be designed as careful optimisations of numerous properties. A simple measure to increase the toughness often needed for milling tools is to increase the binder phase content. However, this will also quickly reduce the wear resistance and also the resistance to plastic deformation. Addition of cubic carbides such as TiC, TaC and NbC is another mean to influence the tool properties, and large additions in combination with high binder phase contents can give relatively good toughness behaviour. However, this addition can have a negative influence on comb crack formation and edge chipping tendencies.

Since it is obviously difficult to improve all tool properties simultaneously, commercial cemented carbide grades have usually been optimised with respect to one or few of the above mentioned wear types. Consequently, they have also been optimised for specific application areas.

US 6,062,776 discloses a coated cutting insert particularly useful for milling of low and medium alloyed steels and stainless steels with raw surfaces such as cast skin, forged skin, hot or cold rolled skin or pre-machined surfaces under unstable conditions. The insert is characterised by a WC-Co cemented carbide with a low content of cubic carbides and a rather low W-alloyed binder phase and a coating including an innermost layer of TiCₓN_{y}O_{z} with columnar grains and a top layer of TiN and an inner layer of κ-Al₂O₃.

US 6,177,178 describes a coated milling insert particularly useful for milling in low and medium alloyed steels with or without raw surface zones during wet or dry conditions. The insert is characterised by a WC-Co cemented carbide with a low content of cubic carbides and a highly W-alloyed binder phase and a coating including an inner layer of TiCₓN_{y}O_{z} with columnar grains, an inner layer of κ-Al₂O₃ and, preferably, a top layer of TiN.

US 6,250,855 discloses a coated milling insert for wet or dry milling of stainless steels of different composition and microstructure. The coated WC-Co based cemented carbide inserts includes a specific composition range of WC-Co without any additions of cubic carbides, a low W-alloyed Co binder and a hard and wear resistant coating including a multilayered structure of sub-layers of the composition (TiₓAl₁₋ₓ)N.

EP 1103635 provides a cutting tool insert particularly useful for wet and dry milling of low and medium alloyed steels and stainless steels as well as for turning of stainless steels. The cutting tool is comprised of a cobalt cemented carbide substrate with a multi-layer refractory coating thereon. The substrate has a cobalt content of 9.0-10.9 wt% and contains 1.0-2.0 wt% TaC/NbC. The coating consists of an MTCVD TiCₓN_{y}O_{z} layer and a multi-layer coating being composed of κ-Al₂O₃ and TiCₓN_{y}O_{z} layers.

It has now been found that enhanced cutting performance can be obtained by combining many different features of the cutting tool. The cutting insert has excellent performance preferably for milling of stainless steels and super alloys, but also for steels in toughness demanding operations. At these cutting conditions, the cutting tool according to the invention displays improved properties with respect to many of the wear types mentioned earlier.

The cutting tool insert according to the present invention includes a cemented carbide substrate with a relatively low amount of cubic carbides, with a medium to highly W-alloyed binder phase and a fine to medium WC grain size. This substrate is provided with a wear resistant coating comprising an equiaxed TiCₓN_{y}O_{z} layer, a columnar TiCₓN_{y}O_{z} layer, and at least one α-Al₂O₃ layer.

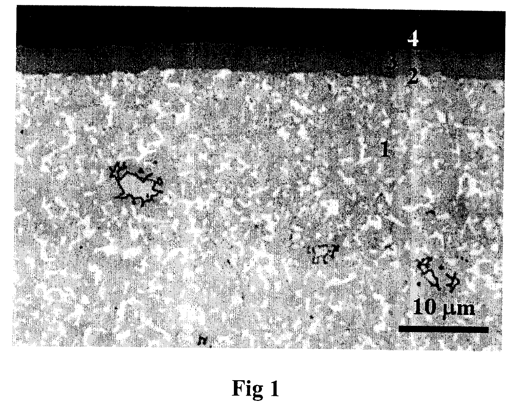

Fig 1 shows in 2500x a coated cemented carbide insert according to the present invention in which
1. A cemented carbide body
2. An innermost TiCₓN_{y}O_{z} layer
3. A TiCₓN_{y}O_{z} layer with columnar grains
4. An α-Al₂O₃ layer

According to the present invention, a coated cutting tool insert is provided with a cemented carbide body having a composition of 11.8-12.4 wt% Co; 1.0-1.8 wt% total amount of cubic carbides of the metals Ti, Nb and Ta; and balance WC. Ti, Ta and/or Nb may also be replaced by other carbides of elements from groups IVb, Vb or VIb of the periodic table.

The cobalt binder phase is medium to highly alloyed with tungsten. The content of W in the binder phase may be expressed as the S-value=σ/16.1, where σ is the measured magnetic moment of the binder phase in µTm³kg⁻¹. The S-value depends on the content of tungsten in the binder phase and increases with a decreasing tungsten content. Thus, for pure cobalt, or a binder in a cemented carbide that is saturated with carbon, S=1, and for a binder phase that contains W in an amount that corresponds to the borderline to formation of η-phase, S=0.78.

It has now been found according to the present invention that improved cutting performance is achieved if the cemented carbide body has an S-value within the range 0.85-0.92.

Furthermore, the mean intercept length of the tungsten carbide phase measured on a ground and polished representative cross section is in the range 0.3-0.8 µm, preferably 0.4-0.8 µm. The intercept length is measured by means of image analysis on micrographs with a magnification of 10000x and calculated as the average mean value of approximately 1000 intercept lengths.

The coating according to a preferred embodiment comprises:
- a first (innermost) layer of TiCₓN_{y}O_{z} with 0.7≤x+y+z≤1, y>x and z<0.2, y>0.7, with equiaxed grains and a total thickness <1 µm preferably >0.1 µm.
- a layer of TiCₓN_{y}O_{z} with 0.7≤x+y+z≤1, preferably with z<0.2, and y>0.2, x>0.4, with a thickness of 1.5-3 µm, with columnar grains.
- a layer of Al₂O₃ consisting of the α-phase. The Al₂O₃ layer has a thickness of 1-3 µm.

In a further preferred embodiment, the cutting tool insert as described above is treated after coating with a wet blasting or brushing operation, such that the surface quality on the rake face of the coated tool is improved.

The method of the present invention includes making a coated cutting tool with a composition of 11.8-12.4 wt% Co; 1.0-1.8 wt% total amount of cubic carbides of the metals Ti, Nb and Ta and balance WC. Ti, Ta and/or Nb may also be replaced by other carbides of elements from groups IVb, Vb or VIb of the periodic table.

The desired mean intercept length depends on the grain size of the starting powders and milling and sintering conditions and has to be determined by experiments. The desired S-value depends on the starting powders and sintering conditions and also has to be determined by experiments.

The layer of TiCₓN_{y}O_{z} with 0.7≤x+y+z≤1, preferably with z<0.2, and y>0.2, x>0.4, having a morphology of columnar grains, is deposited with MTCVD-technique onto the cemented carbide using acetonitrile as the carbon and nitrogen source for forming the layer in the temperature range of 700-950°C.

The innermost TiCₓN_{y}O_{z} layer and alumina layers are deposited according to known technique.

The invention also relates to the use of cutting tool inserts according to the above for milling of stainless steels and super alloys at cutting speeds of 30-500 m/min, preferably 50-400 m/min, with mean chip thickness values of 0.04-0.20 mm, depending on cutting speed and insert geometry.

### Example 1.

Grade A: A cemented carbide substrate in accordance with the invention with the composition 12 wt% Co, 1.3 wt% TaC, 0.2 wt% NbC and balance WC, with a binder phase alloyed with W corresponding to an S-value of 0.90 was produced by conventional milling of powders, pressing of green compacts and subsequent sintering at 1430°C. Investigation of the microstructure after sintering showed that the mean intercept length of the tungsten carbide phase was 0.59 µm. The substrate was coated in accordance with the invention with a 0.2 µm thick layer of TiCₓN_{y}O_{z} layer with z<0.1 and y>0.6, having equiaxed grains, a 2.5 µm thick layer of columnar TiCₓN_{y}O_{z} deposited at 835-850°C with acetonitrile as carbon and nitrogen source, yielding an approximated carbon to nitrogen ratio x/y=1.5 with z<0.1, and a 1.2 µm thick layer of α-Al₂O₃ deposited at approximately 1000°C. Analysis of the Al₂O₃ layer with XRD showed no traces of κ-Al₂O₃.

Grade B: A substrate with the same chemical composition and manufacturing route as the substrate of grade A (according to the invention) was prepared with a coarser WC powder, resulting in a mean intercept length of the WC phase of 0.70 µm. The substrate was coated according to grade A in accordance with the invention.

Grade C: A substrate with composition 12 wt% Co, 0.52 wt% Cr and balance WC, a binder phase alloyed with W corresponding to an S-value of 0.87, and a mean intercept length of WC in the sintered body of 0.58 µm was produced by conventional milling of powders, pressing of green compacts and subsequent sintering at 1430°C was combined with a coating according to Grade A (according to the invention).

Inserts according to Grade A, Grade B and Grade C were tested in a face milling application where flood coolant was applied.

| Operation | Face milling |
|---|---|
| Cutter diameter | 80 mm |
| Work piece | Bar, 600 mm x 75 mm |
| Material | SS2333 |
| Insert type | SEKN1203 |
| Cutting speed | 300 m/min |
| Feed | 0.25 mm/tooth |
| Number of teeth | 6 |
| Depth of cut | 3.5 mm |
| Width of cut | 35 mm |
| Coolant | Yes |
| | |

| Results | Tool life (min) |
|---|---|
| Grade A (grade according to invention) | 10 |
| Grade B (grade according to invention) | 9 |
| Grade C (coating according to invention) | 6 |

The tool life was limited by chipping of the edges in connection to comb cracks. The test shows a small influence from the WC grain size and poor properties of materials with Cr added as a grain-growth inhibiting agent instead of cubic carbides like TaC and NbC.

### Example 2:

Grade D: The substrate of Grade A (according to the invention) was coated with a 0.3 µm thick layer of TiCₓN_{y}O_{z}, having equiaxed grains, a 2.5 µm thick layer of columnar TiCₓN_{y}O_{z} deposited at 835-850°C, a 1.3 µm thick layer of κ-Al₂O₃ deposited at approximately 1000°C. XRD analysis of the coating showed no traces of the α-Al₂O₃ phase Al₂O₃.

Inserts of Grade A and Grade D were tested in a face milling operation of an Inconel 718 component.

| Operation | Face milling |
|---|---|
| Cutter diameter | 63 mm |
| Work piece | Block |
| Material | Inconel 718 |
| Insert type | OFMT0504 |
| Cutting speed | 40 m/min |
| Feed | 0.12 mm/tooth |
| Number of teeth | 6 |
| Depth of cut | 2 mm |
| Width of cut | 38 mm |
| Coolant | Emulsion |
| Time of cut | 12 min |
| | |

| Results | Flank wear |
|---|---|
| Grade A (grade according to invention) | 0.15 mm |
| Grade D (substrate according to invention) | 0.20 mm |

The test was stopped before maximum tool life was achieved and the wear of the inserts was studied. The inserts of Grade A showed lower average flank wear then inserts of Grade D and in addition, the edge chipping tendencies were less pronounced on inserts of Grade A. I.e. inserts according to Grade A show better wear resistance and toughness behaviour when compared to inserts according to Grade D.

### Example 3:

Grade E: The substrate of Grade A (according to the invention) was coated with a coating structure according to Grade A with the addition of an outer 0.4 µm thick nitrogen-rich TiCₓN_{y}O_{z} layer.

| Operation | Square shoulder milling |
|---|---|
| Work piece | Bar |
| Material | SS2333 |
| Insert type | APKT1604 |
| Cutting speed | 250 m/min |
| Cutter diameter | 25 mm |
| Feed | 0.28 mm/tooth |
| Number of teeth | 2 |
| Depth of cut | 2.5 mm |
| Width of cut | 3-12 mm |
| Coolant | No |
| | |

| Results | Tool life (min) |
|---|---|
| Grade A (grade according to invention) | 17 |
| Grade E (substrate according to invention) | 14 |

The tool life was limited by flank wear and edge chipping. When using inserts in Grade A, the tendency for chips adhering to the cutting inserts is much lower than when using inserts in Grade E. The poorer tool life of Grade E is due to more pronounced edge chipping occurring as a result of adhesive wear and re-cutting of chips.

### Example 4:

Grade F: A commercial cemented carbide cutting insert from a competitor with the composition 10.5 wt% Co, 0.43 wt% Cr and balance WC. The binder phase is alloyed with W corresponding to an S-value of 0.91, and the mean intercept length of the WC is 0.6 µm. The insert is coated with 4.9 µm thick coating with alternating layers of TiN and TiₓAl₁₋ₓN.

| Operation | Face milling |
|---|---|
| Cutter diameter | 80 mm |
| Work piece | Bar, 300 mm x 80 mm |
| Material | SS2343 |
| Insert type | SEET13 |
| Cutting speed | 275 m/min |
| Feed | 0.17 mm/tooth |
| Number of teeth | 1 |
| Depth of cut | 4 mm |
| Width of cut | 50 mm |
| Coolant | No |
| Time of cut | 13 min |
| | |

| Results | Maximum flank wear |
|---|---|
| Grade A (grade according to invention) | 0.18 |
| Grade F (prior art) | 0.45 |

The wear of the inserts was measured when maximum tool life was reached for the worst grade.

## Claims

1. A cutting tool insert, comprising a cemented carbide body and a coating, particularly useful for milling of stainless steels and super alloys and milling of steels in toughness demanding applications, wherein said body has a composition of 11.8-12.4 wt% Co; 1.0-1.8 wt% total amount of cubic carbides of the metals Ti, Nb and Ta and balance WC, the WC grains having a mean intercept length of 0.4-0.8 µm, the binder phase being alloyed with W corresponding to an S-value of 0.82-0.94, and said coating comprises
- a first (innermost) layer of TiCₓN_{y}O_{z} with 0.7≤x+y+z≤1, y>x and z<0.2, y>0.7, with equiaxed grains and a total thickness <1 µm, preferably >0.1 µm,
- a layer of TiCₓN_{y}O_{z} with 0.7≤x+y+z≤1, with z<0.2, x>0.4 and y>0.2, with a thickness of 1.5-3 µm, with columnar grains and
- a layer of Al₂O₃ consisting of the α-phase with a thickness of 1-3 µm.

2. Use of a cutting tool inserts according to claim 1 for milling of stainless steels and super alloys at cutting speeds of 50-400 m/min, with mean chip thickness values of 0.04-0.25 mm, depending on cutting speed and insert geometry.

## Patentansprüche

1. Schneidwerkzeugeinsatz, der einen Cermet Körper und eine Beschichtung aufweist, der insbesondere verwendbar ist für das Fräsen von rostfreien Stählen, Superlegierungen und Stählen in Anwendungen, bei welchen es auf Zähigkeit ankommt, wobei der Körper eine Zusammensetzung mit 11,8-12,4 Gew.-% Co, 1,0-1,8 Gew.-% Gesamtgehalt an kubischen Carbiden der Metalle Ti, Nb und Ta und im Übrigen WC hat, wobei die WC Körner einen mittleren Durchmesser von 0,4-0,8 µm haben, die Binderphase mit W entsprechend einem S-Wert von 0,82-0,94 legiert ist, und die Beschichtung aufweist:
- Eine erste (innerste) Schicht aus TiCₓN_{y}O mit 0,7 <x+y+z<1, y>x und z<0,2, y>0,7, mit gleichachsigen Körnern und einer absoluten Dicke <1 µm, bevorzugt >0.1 µm,
- eine Schicht aus TiCₓN_{y}O mit 0,7<x+y+z<1, mit z<0,2, x>0,4 und y>0,2, mit einer Dicke von 1,5-3 µm und säulenförmigen Körnern und
- eine Schicht aus Al₂O₃ bestehend aus einer α-Phase mit einer Dicke von 1-3 µm.

2. Verwendung eines Schneidwerkzeugeinsatzes nach Anspruch 1 für das Fräsen von rostfreiem Stahl und Superlegierungen bei einer Geschwindigkeit von 50-400 m/min und einer mittleren Spandicke von 0,04-0,25 mm, abhängig von der Schneidgeschwindigkeit und der Einsatzgeometrie.

## Revendications

1. Insert d'outil de coupe, comprenant un corps de carbure cémenté et un revêtement, particulièrement utile pour le fraisage d'aciers inoxydables et de superalliages et le fraisage d'aciers dans des applications demandant de la ténacité, dans lequel ledit corps a une composition de 11,8 à 12,4 % en poids de Co ; de 1,0 à 1,8 % en poids de quantité totale de carbures cubiques des métaux Ti, Nb et Ta et le reste de WC, les grains de WC ayant une longueur d'interception moyenne de 0,4 à 0,8 µm, la phase de liant étant alliée avec du W correspondant à une valeur S de 0,82 à 0,94, et ledit revêtement comprend
- une première couche (la plus à l'intérieur) de TiCₓN_{y}O_{z} avec 0,7≤x+y+z≤1, y>x et z<0,2, y>0,7, avec des grains équiaxiaux et une épaisseur totale < 1 µm, de préférence > 0,1 µm,
- une couche de TiCₓN_{y}O_{z} avec 0,7≤x+y+z≤1, avec z<0,2, x>0,4, y>0,2, avec une épaisseur de 1,5 à 3 µm, avec des grains columnaires et
- une couche de Al₂O₃ constituée de la phase α avec une épaisseur de 1 à 3 µm.

2. Utilisation d'un insert d'outil de coupe selon la revendication 1 pour le fraisage d'aciers inoxydables et de superalliages à des vitesses de coupe de 50 à 400 m/min, avec des valeurs d'épaisseur de copeaux moyennes de 0,04 à 0,25 mm, en fonction de la vitesse de coupe et de la géométrie d'insert.
